# EUROPÄISCHE PATENTSCHRIFT

(11) **EP 3 472 934 B1**
(45) Veröffentlichungstag und Bekanntmachung des Hinweises auf die Patenterteilung: **21.10.2020**
(21) Anmeldenummer: 17730149.6
(22) Anmeldetag: 14.06.2017
(51) Int. Cl.: H03K 17/082

(54) **LEISTUNGSHALBLEITERSCHALTUNG**
POWER SEMICONDUCTOR CIRCUIT
CIRCUIT À SEMI-CONDUCTEUR DE PUISSANCE

(30) Priorität: 16.06.2016 DE 102016210798
(43) Veröffentlichungstag der Anmeldung: 24.04.2019
(73) Patentinhaber: Valeo Siemens eAutomotive Germany GmbH, 91056 Erlangen (DE)
(72) Erfinder: KURING, Carsten, 12526 Berlin (DE)
(74) Vertreter: Dr. Gassner & Partner mbB
(86) Internationale Anmeldenummer: PCT/EP2017/064554
(87) Internationale Veröffentlichungsnummer: WO 2017/216228

(56) Entgegenhaltungen:
- EP-A1- 2 858 245
- GB-A- 2 532 215
- US-B1- 7 932 754

## Beschreibung

Die Erfindung betrifft eine kurz als Leistungshalbleiterschaltung bezeichnete Schaltung mit einem Leistungshalbleiter, insbesondere eine Schaltung mit einem Leistungshalbleiter, welche mittels eines getaktet angesteuerten Leistungshalbleiters zum getakteten Aktivieren einer angeschlossenen Last bestimmt ist, welche zumindest parasitäre und/oder diskrete Induktivitäten umfasst.

Von einer zu schaltenden Last umfasste Induktivitäten, nämlich parasitäre Induktivitäten und/oder diskrete Induktivitäten ohne Freilaufpfad, führen am getakteten Leistungshalbleiter während des Ausschaltvorgangs zwangsweise zu transienten Überspannungen mit hohen Spannungsspitzen, da die Induktivität oder die Induktivitäten den Stromfluss aufrechterhalten will bzw. wollen. Solche Überspannungen können zu einer Zerstörung oder beschleunigten Degeneration des Leistungshalbleiters führen. Zur Vermeidung solcher Überspannungen wird oftmals eine sogenannte Active-Clamp-Beschaltung des Leistungshalbleiters verwendet.

Dabei werden eine Z-Diode und eine Diode zwischen den Drain- und den Gate-Anschluss des jeweiligen Leistungshalbleiters geschaltet, wobei die Durchbruchsspannung der Z-Diode kleiner als die Durchbruchsspannung des Leistungshalbleiters ist. Im Falle einer Spannungsspitze am Drain-Anschluss und einer resultierenden Überspannung am sperrenden Leistungshalbleiterübergang wird die Z-Diode oberhalb deren Durchbruchsspannung leitend und das Gate-Potential des Leistungshalbleiters wird angehoben, wodurch der Leistungshalbleiter in den Linearbetrieb gelangt. So kann die in der Induktivität gespeicherte Energie im teilweise leitfähigen Leistungshalbleiterübergang in Wärme umgewandelt und somit sicher abgebaut werden.

Nachteilig bei dieser bekannten Schaltung zum Schutz des Leistungshalbleiters ist jedoch, dass das Prinzip des Active-Clamping nur dann erfolgreich angewandt werden kann, wenn sicher und reproduzierbar erkannt werden kann, ob die transiente Überspannung einen im Folgenden als Clamping-Spannung bezeichneten Schwellwert überschreitet. Eine genaue Einstellung der Active-Clamping-Schaltung ist aufgrund von vergleichsweise hohen fertigungs-, temperatur- und/oder alterungsbedingten Toleranzen speziell der von der Active-Clamping-Schaltung umfassten Z-Diode oder mehrerer von der Active-Clamping-Schaltung umfasster Z-Dioden allerdings sehr Z schwierig.

Aus der GB 2 532 215 A ist eine Active-Clamping-Schaltung bekannt, bei der die Clamping-Spannung einstellbar ist.

Aus der US 7 932 754 B1 ist eine Schaltung bekannt, bei der eine Gatespannung eines Schaltelements adaptiv so einstellt wird, dass ein im Wesentlichen konstanter Spannungsabfall über dem Schaltelement auftritt. Der Spannungsabfall über dem Schaltelement kann auf einen Referenzpegel eingestellt werden, der angepasst wird, wenn eine Änderung der Schaltungsbedingungen festgestellt wird.

Eine Aufgabe der Erfindung besteht ausgehend davon darin, eine alternative Leistungshalbleiterschaltung anzugeben, die einen Schaltungsteil zum Schutz des Leistungshalbleiters gegen transiente Überspannungen umfasst. Eine spezielle Aufgabe besteht darin, eine Leistungshalbleiterschaltung mit einem Schaltungsteil zum Schutz des Leistungshalbleiters gegen transiente Überspannungen anzugeben, die einfach und unkompliziert auf eine jeweils gewünschte Clamping-Spannung einstellbar ist.

Diese Aufgabe wird erfindungsgemäß mittels einer Leistungshalbleiterschaltung mit den Merkmalen des Anspruchs 1 gelöst. Dabei ist bei einer Leistungshalbleiterschaltung mit einem zum Schalten einer Last, welche diskrete und/oder parasitäre Induktivitäten umfasst, bestimmten Leistungshalbleiter, wobei beim Abschalten der Last mittels des Leistungshalbleiters transiente Überspannungen am Leistungshalbleiter resultieren, Folgendes vorgesehen: Die Leistungshalbleiterschaltung umfasst einen Schaltungsteil zum Schutz des Leistungshalbleiters gegen transiente Überspannungen. Dieser Schaltungsteil umfasst einen Komparator. Dieser ist mit einem ersten Eingang mittelbar oder unmittelbar an einen Anschlusspunkt der Last am Leistungshalbleiter angeschlossen. An einem zweiten Eingang ist dem Komparator eine vorgegebene oder vorgebbare Referenzspannung zuführbar und wird dem Komparator beim Betrieb der Leistungshalbleiterschaltung zugeführt. Mittels eines Ausgangs des Komparators ist eine Aktivierung des Leistungshalbleiters bewirkbar und wird beim Betrieb der Leistungshalbleiterschaltung je nach Zustand des Ausgangs eine Aktivierung des Leistungshalbleiters bewirkt. Der Ausgang des Komparators ergibt sich dabei aufgrund eines Vergleichs der an den beiden Eingängen anliegenden Potentiale.

Der Vorteil der Erfindung besteht darin, dass die Clamping-Spannung, ab welcher der zum Schutz des Leistungshalbleiters bestimmte Schaltungsteil wirksam wird, mittels der Referenzspannung vorgegeben wird. Dies vermeidet die bisherige Situation, bei der die Clamping-Spannung aufwendig mittels einzelner elektronischer Bauteile und deren passender Auswahl entsprechend jeweils charakteristischer Größen (bei der Z-Diode entsprechend deren Durchbruchsspannung) vorgegeben werden muss. Mittels des Komparators erfolgt ein Vergleich der am Anschlusspunkt der Last, nämlich dem Anschlusspunkt der Last am Leistungshalbleiter, anliegenden Spannung mit der Referenzspannung. An diesem Anschlusspunkt, zum Beispiel dem Drain-Anschluss des Leistungshalbleiters, liegt im Falle einer beim Ausschalten der Last resultierenden transienten Überspannung auch diese transiente Überspannung an. Die transiente Überspannung wird also unmittelbar oder mittelbar mit der Referenzspannung verglichen. Ein unmittelbarer oder mittelbarer Vergleich der beiden Spannungen mittels des Komparators hängt davon ab, ob dieser unmittelbar oder mittelbar an den Anschlusspunkt der Last am Leistungshalbleiter angeschlossen ist. Bei einer besonderen Ausführungsform der hier vorgeschlagenen Neuerung ist der Komparator über zumindest einen Widerstand eines Spannungsteilers, also nicht unmittelbar, sondern mittelbar, an den Anschlusspunkt der Last am Leistungshalbleiter angeschlossen.

Vorteilhafte Ausgestaltungen der Erfindung sind Gegenstand der Unteransprüche. Dabei verwendete Rückbeziehungen weisen auf die weitere Ausbildung des Gegenstandes des Hauptanspruches durch die Merkmale des jeweiligen Unteranspruches hin. Sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist. Schließlich ist darauf hinzuweisen, dass die hier angegebene Schaltung auch entsprechend der abhängigen Verfahrensansprüche weitergebildet sein kann und umgekehrt, zum Beispiel indem die Schaltung Mittel zur Ausführung einzelner Verfahrensschritte aufweist.

Bei einer Ausführungsform der Leistungshalbleiterschaltung ist dem Komparator ein Spannungsteiler vorgeschaltet, insbesondere ein ohmscher Widerstand eines mit zwei ohmschen Widerständen gebildeten Spannungsteilers. Mittels des Spannungsteilers wird die am Anschlusspunkt der Last am Leistungshalbleiter auftretende transiente Überspannung entsprechend der jeweiligen Widerstandswerte proportional aufgeteilt. Die dem Komparator zum Vergleich zugeführte Referenzspannung kann demnach entsprechend dem Widerstandsverhältnis des Spannungsteilers reduziert werden. Zudem fungiert der dem Leistungshalbleiter vorgeschaltete Teil des Spannungsteilers als Strombegrenzungswiderstand.

Erfindungsgemäß ist die Referenzspannung mittels einer Referenzspannungsschaltung einstellbar. An dieser liegt im Betrieb eine Betriebsspannung an. Die Referenzspannungsschaltung umfasst in parallelen Zweigen jeweils eine Reihenschaltung mit einem elektronischen Schaltelement und einem Referenzwiderstand. Alle von der Referenzspannungsschaltung umfassten Schaltelemente sind einzeln ansteuerbar. Die Betriebsspannung liegt im Betrieb auch am Komparator an.

Jede Reihenschaltung stellt einen innerhalb der Referenzspannungsschaltung zuschaltbaren Pfad dar. Die bei einer Aktivierung eines Schaltelements und der damit bewirkten Aktivierung eines jeweiligen Pfads über dem jeweiligen Widerstand abfallende Spannung summiert sich mit den über anderen aktivierten Pfaden abfallenden Spannungen zu der von der Referenzspannungsschaltung abgegebenen Referenzspannung. Bei günstiger Wahl der Widerstandswerte, zum Beispiel unterschiedliche Widerstandswerte in allen Pfaden, ergeben sich bei n zuschaltbaren Pfaden bis zu 2ⁿ unterschiedliche Referenzspannungspegel, die sich mittels der Referenzspannungsschaltung erzeugen lassen. Beim Betrieb einer Leistungshalbleiterschaltung, welche eine solche Referenzspannungsschaltung umfasst oder die mit einer solchen Referenzspannungsschaltung verbunden ist, wird durch gezielte Aktivierung einzelner Schaltelemente der Referenzspannungsschaltung eine jeweils gewünschte Referenzspannung eingestellt und diese wird beim Betrieb der Leistungshalbleiterschaltung dem Komparator zugeführt.

Bei einem Verfahren zum Betrieb einer Leistungshalbleiterschaltung der hier und im Folgenden beschriebenen Art wird mittels einer vorgebbaren Referenzspannung eine Clamping-Spannung entsprechend einer jeweiligen Betriebssituation des Leistungshalbleiters eingestellt. Mittels der Einstellung der Referenzspannung entsprechend einer Betriebssituation des Leistungshalbleiters kann zum Beispiel berücksichtigt werden, dass die Durchbruchsspannung des Leistungshalbleiters und damit auch die zulässige Höhe der transienten Überspannung mit der Temperatur des Leistungshalbleiters (Chiptemperatur) steigt. Entsprechend kann also die Referenzspannung temperaturabhängig angepasst, insbesondere erhöht werden. Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Das Ausführungsbeispiel ist nicht als Einschränkung der Erfindung zu verstehen. Der Rahmen der Erfindung wird durch den Schutzumfang der Ansprüche definiert.

Es zeigen
- FIG 1: eine Leistungshalbleiterschaltung mit einer bekannten Active-Clamping-Schaltung,
- FIG 2: eine Leistungshalbleiterschaltung mit einem Leistungshalbleiter und einem Schaltungsteil zum Schutz des Leistungshalbleiters vor transienten Überspannungen und
- FIG 3: eine zusammen mit einer Leistungshalbleiterschaltung gemäß FIG 2 verwendbare Referenzspannungsschaltung.

Moderne Leistungshalbleiter, insbesondere Leistungs-MOSFETs, werden speziell in Schaltanwendungen, z.B. in DC/DC-Wandlern, in einem sogenannten PWM-Betrieb eingesetzt.

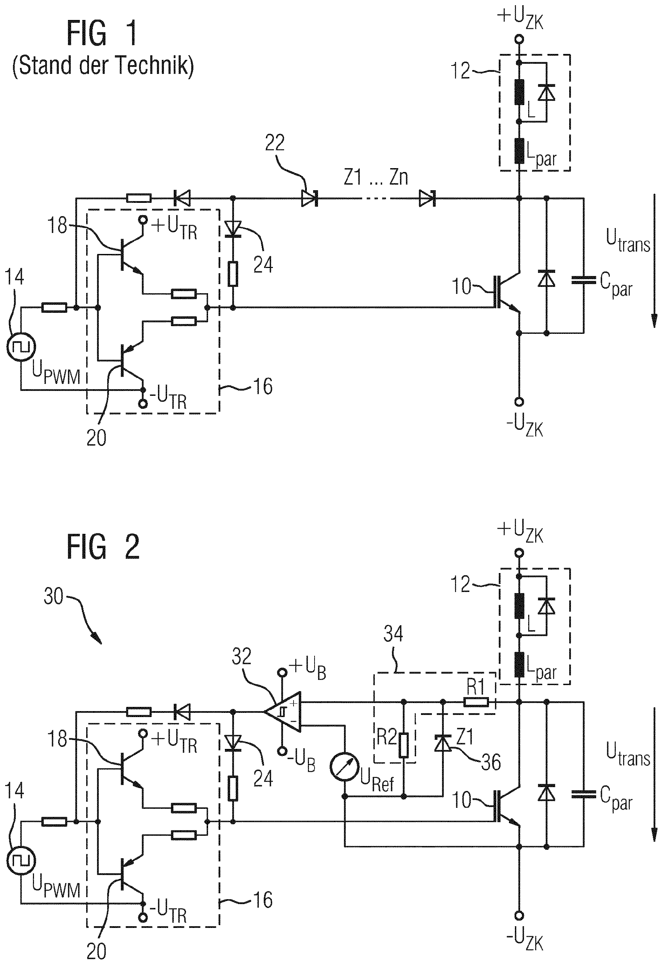

FIG 1 zeigt eine Schaltung mit einem Leistungshalbleiter 10, wobei der Leistungshalbleiter 10 zum Schalten einer angeschlossenen Last 12 bestimmt ist, welche parasitäre Induktivitäten (Lₚₐᵣ) und diskrete Induktivitäten (L) umfasst. Beim PWM-Betrieb erfolgt die Ansteuerung des Leistungshalbleiters 10 mittels einer Signalquelle 14, welche ein pulsweitenmoduliertes Signal (PWM-Signal; U_{PWM}) ausgibt. Aufgrund der Ansteuerung mittels einer solchen Signalquelle 14 wird der Leistungshalbleiter 10 wechselweise im voll eingeschalteten und voll ausgeschalteten Zustand betrieben.

Die weitere Beschreibung wird - ohne Verzicht auf eine weitergehende Allgemeingültigkeit - anhand einer Signalquelle 14 fortgesetzt, welche ein pulsweitenmoduliertes und als Ansteuersignal fungierendes Signal (U_{PWM}) ausgibt. Allgemein handelt es sich bei der Signalquelle 14 um eine Vorrichtung, welche ein getaktetes Ansteuersignal ausgibt. Dies ist im Folgenden stets mitzulesen.

Das pulsweitenmodulierte Signal - oder allgemein ein von der Signalquelle 14 generiertes Ansteuersignal - wird einer Treiberschaltung 16 zugeführt. Diese umfasst zwei komplementäre Halbleiterschalter, nämlich einen während des positiven Pulses des Ansteuersignals leitenden ersten Treiberschalter 18 und einen während des negativen Pulses des Ansteuersignals leitenden zweiten Treiberschalter 20, sowie jeweils in Stromflussrichtung nach- bzw. vorgeschaltete Strombegrenzungswiderstände. Über diese sind der erste Treiberschalter 18 und der zweite Treiberschalter 20 mit dem Gate-Anschluss des Leistungshalbleiters 10 verbunden. Der erste Treiberschalter 18 ist zum Beispiel als npn-Transistor und der zweite Treiberschalter 20 als pnp-Transistor ausgeführt.

Während des positiven Pulses des Ansteuersignals wird das Potential einer am ersten Treiberschalter 18 anliegenden positiven Treiberspannung +U_{TR} an den Gate-Anschluss des Leistungshalbleiters 10 angelegt. Die positive Treiberspannung +U_{TR} ist so eingestellt, dass aufgrund der positiven Treiberspannung +U_{TR} ein Durchschalten des Leistungshalbleiters 10 resultiert. Die Drain-Source-Strecke des Leistungshalbleiters 10 wird also während des positiven Pulses des Ansteuersignals leitend und die jeweils angeschlossene Last 12 wird aktiviert.

Während des negativen Pulses des Ansteuersignals sperrt der erste Treiberschalter 18, während der zweite Treiberschalter 20 leitet, so dass eine am zweiten Treiberschalter 20 anliegende negative Treiberspannung -U_{TR} am Gate-Anschluss des Leistungshalbleiters 10 anliegt. Die negative Treiberspannung ist negativ im Vergleich zu der positiven Treiberspannung +U_{TR} und so eingestellt, dass aufgrund der negativen Treiberspannung -U_{TR} der Leistungshalbleiter 10 sperrt. Die Drain-Source-Strecke des Leistungshalbleiters 10 wird folglich während des negativen Pulses des Ansteuersignals nicht-leitend und die Last 12 entsprechend deaktiviert. Aufgrund der parasitären und/oder diskreten Induktivitäten der Last 12 treiben diese den mittels des Leistungshalbleiters 10 unterbrochenen Strom zumindest kurzzeitig zunächst weiter und es ergeben sich eine Spannungsspitze am Drain-Anschluss des Leistungshalbleiters 10 und eine Überspannung über der Drain-Source-Strecke des Leistungshalbleiters 10.

Diese Überspannung liegt nur sehr kurz an, nämlich nur solange die Induktivitäten der Last 12 aufgrund der dort gespeicherten elektrischen Energie den unterbrochenen Strom treiben. Die Dauer der Überspannungssituation beträgt üblicherweise unter einer Millisekunde (< 1 ms). Die Überspannung wird entsprechend im Folgenden als transiente Überspannung Utrans bezeichnet. Die transiente Überspannung Utrans kann allerdings trotz der kurzen Dauer zur Zerstörung oder zur beschleunigten Degeneration des Leistungshalbleiters 10 führen. Deshalb ist man bestrebt, solche transiente Überspannungen Uₜᵣₐₙₛ zu vermeiden. Im Stand der Technik ist insoweit eine sogenannte Active-Clamping-Schaltung bekannt und die in FIG 1 gezeigte Schaltung umfasst eine solche Active-Clamping-Schaltung, bei der eine Z-Diode 22 und eine Diode 24 zwischen den Drain-Anschluss des Leistungshalbleiters 10 und den Gate-Anschluss des Leistungshalbleiters 10 geschaltet sind. Bei der gezeigten Ausführungsform umfasst die Active-Clamping-Schaltung eine Z-Dioden-Strecke mit einer Mehrzahl von in Reihe geschalteten Z-Dioden 22.

Im Falle einer transienten Überspannung Utrans oberhalb der Durchbruchsspannung der oder jeder Z-Diode 22 wird diese bzw. die Z-Dioden-Strecke leitend. Über den Strompfad mit der Diode 24 führt dies zu einer Anhebung des Gate-Potentials. Dadurch wird der Leistungshalbleiter 10 im linearen Betrieb zumindest teilweise leitend und die in den Induktivitäten der Last 12 gespeicherte Energie kann über den Leistungshalbleiter 10 abfließen. Über einen zu der Diode 24 elektrisch parallelen Pfad erfolgt gleichzeitig eine Ansteuerung der Treiberschaltung 16, so dass der erste Treiberschalter 18 durchschaltet, während der zweite Treiberschalter 20 sperrt. Mit dem Abklingen der transienten Überspannung Utrans endet die Ansteuerung der Treiberschaltung 16, so dass der erste Treiberschalter 18 sperrt und der zweite Treiberschalter 20 durchschaltet. Das aufgrund der transienten Überspannung Utrans erhöhte Potential am Gate-Anschluss des Leistungshalbleiters 10 wird dann über den zweiten Treiberschalter 20 abgebaut. Damit endet schließlich die kurzzeitige Aktivierung des Leistungshalbleiters 10 im linearen Betrieb und der Stromkreis mit der Last 12 ist unterbrochen und die Last 12 deaktiviert. Auch über den Weg der Ansteuerung des Leistungshalbleiters 10 und der Treiberschaltung 16 wird ein Teil der in den Induktivitäten der Last 12 gespeicherten Energie abgebaut.

Problematisch bei einer solchen Leistungshalbleiterschaltung und der davon umfassten Active-Clamping-Schaltung sind vor allem die vergleichsweise hohen fertigungs-, temperatur- und/oder alterungsbedingten Toleranzen der Z-Diode 22 oder der Z-Dioden 22 bezüglich deren jeweiliger Durchbruchsspannung. Die Durchbruchsspannung einer einzelnen Z-Diode 22 oder - bei einer Z-Dioden-Strecke - die Durchbruchsspannung der Reihenschaltung der davon umfassten Z-Dioden 22 bestimmt die detektierbare transiente Überspannung Utrans. Eine transiente Überspannung Utrans unterhalb dieser Durchbruchsspannung wird nicht erkannt und die damit verbundene elektrische Energie dementsprechend nicht in der zuvor beschriebenen Art und Weise abgebaut. Eine besonders genaue Festlegung der Durchbruchsspannung ist daher wünschenswert. Aufgrund der oben genannten Toleranzen ist gerade diese genaue Festlegung erschwert. Die Auslegung muss folglich unter Berücksichtigung der genannten Toleranzen erfolgen und benötigt daher typischerweise große Reserven. Aufgrund solcher Reserven wird eine Active-Clamping-Schaltung der in FIG 1 gezeigten Art gegebenenfalls wirksam, ohne dass die Betriebssituation des Leistungshalbleiters 10 dies erfordern würde.

FIG 2 zeigt eine Ausführungsform einer Schaltung mit einem Leistungshalbleiter 10 (Leistungshalbleiterschaltung 30) gemäß dem hier vorgestellten Ansatz. Die Leistungshalbleiterschaltung 30 umfasst - genau wie in FIG 1 - eine Signalquelle 14 zum Abgeben eines Ansteuersignals und eine Treiberschaltung 16 mit einem ersten und einem zweiten Treiberschalter 18, 20. Der Leistungshalbleiter 10 wird auch hier wieder zum getakteten Schalten einer Last 12 verwendet, welche parasitäre Induktivitäten Lₚₐᵣ und diskrete Induktivitäten L umfasst. Die getaktete Aktivierung des Leistungshalbleiters 10 erfolgt auch hier, genau wie beim Stand der Technik gemäß FIG 1, mittels eines von einer Signalquelle 14 ausgegebenen Ansteuersignals, insbesondere mittels eines pulsweitenmodulierten Ansteuersignals.

Die Besonderheit besteht darin, dass die beim Abschalten am Leistungshalbleiter 10 auftretende transiente Überspannung Utrans mittels eines Komparators 32 mit einer vorgegebenen oder vorgebbaren Referenzspannung U_{Ref} verglichen wird. Bei der in FIG 2 gezeigten Ausführungsform wird die transiente Überspannung Utrans mittels eines grundsätzlich optionalen Spannungsteilers 34 mit zwei ohmschen Widerständen (R1, R2) proportional aufgeteilt. Einer der Widerstände (R1) des Spannungsteilers 34 bewirkt dann vorteilhaft auch noch eine Strombegrenzung und der über dem anderen Widerstand (R2) abfallende Teil der transienten Überspannung Utrans wird mittels des Komparators 32 mit der Referenzspannung U_{Ref} verglichen.

Die Referenzspannung U_{Ref} liegt zwischen dem Source-Anschluss des Leistungshalbleiters 10 und dem invertierenden Eingang des Komparators 32 an. Der nicht-invertierende Eingang des Komparators 32 ist mittelbar, nämlich über einen Teil des Spannungsteilers 34, an den Drain-Eingang des Leistungshalbleiters 10 angeschlossen und über diesen Weg detektiert der Komparator 32 eine eventuelle transiente Überspannung Utrans und vergleicht diese mit der Referenzspannung U_{Ref}.

Für den Fall, dass die transiente Überspannung Utrans den jeweils eingestellten Wert der Referenzspannung U_{Ref} erreicht oder überschreitet (Utrans ≥ U_{Ref}), wird mittels des Ausgangs des Komparators 32 zum einen über den Strompfad mit der Diode 24 das Gate-Potential des Leistungshalbleiters 10 angehoben, so dass dieser in den Linearbetrieb gelangt und teilweise leitend wird, und zum anderen die Treiberschaltung 16 angesteuert. Über den teilweise leitenden Leistungshalbleiter 10 kann - wie oben im Zusammenhang mit FIG 1 beschrieben - die in den Induktivitäten der Last 12 gespeicherte Energie abfließen. Die gleichzeitige kurzzeitige Aktivierung der Treiberschaltung 16 hat den ebenfalls oben im Zusammenhang mit FIG 1 bereits beschriebenen Effekt, nämlich dass das aufgrund der transienten Überspannung Utrans resultierende erhöhte Potential am Gate-Anschluss des Leistungshalbleiters 10 nicht unmittelbar aufgrund des ansonsten durchgeschalteten zweiten Treiberschalters 20 und der an diesem anliegenden negativen Treiberspannung -U_{TR} wieder verschwindet. Somit ist während der Dauer des Anstehens der transienten Überspannung Utrans ein zumindest kurzzeitiger linearer Betrieb des Leistungshalbleiters 10 möglich.

Die Verwendung einer vorgegebenen oder vorgebbaren Referenzspannung U_{Ref} erlaubt eine exakte Einstellung der Höhe der zu detektierenden transienten Überspannung Utrans. Für die Einstellung der Schalt- oder Ansprechschwelle der hier vorgeschlagenen Active-Clamping-Schaltung spielen demnach die oben erwähnten Toleranzen keine Rolle. Eine grundsätzlich optionale Z-Diode 36 dient dem Schutz des Komparators 32.

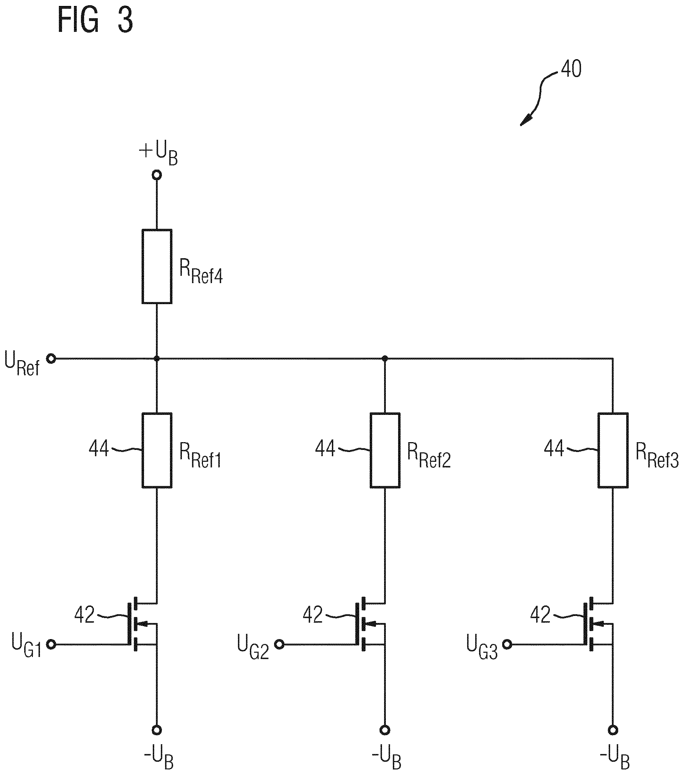

Die Darstellung in FIG 3 zeigt eine als Referenzspannungsschaltung 40 fungierende Schaltung zur Abgabe einer einstellbaren Referenzspannung U_{Ref}. An der Referenzspannungsschaltung 40 liegt im Betrieb eine Betriebsspannung U_{B} an, aus der die Referenzspannung U_{Ref} abgeleitet wird. Die Referenzspannungsschaltung 40 ist ein Spannungsteiler und umfasst auf einer Seite des Spannungsteilers ein Widerstandsnetzwerk mit zumindest zwei parallelen Zweigen/Pfaden. In jedem Zweig/Pfad umfasst die Referenzspannungsschaltung 40 jeweils eine Reihenschaltung mit einem elektronischen Schaltelement 42 und einem Referenzwiderstand 44. Als elektronische Schaltelemente 42 kommen zum Beispiel MOSFETs in Betracht. Jedes Schaltelement 42 ist einzeln ansteuerbar, zum Beispiel mittels einer hier nicht gezeigten Ansteuerschaltung. Das Ansteuern eines Schaltelements 42 bewirkt eine Aktivierung des jeweiligen Pfads und damit eine Veränderung des ohmschen Widerstands der Gesamtheit der parallelen Pfade sowie im Ergebnis eine Veränderung der Verhältnisse der Widerstandswerte der beiden Seiten des Spannungsteilers. Die Gesamtheit der parallelen Pfade bildet eine Seite des Spannungsteilers. An einem Mittelabgriff des Spannungsteilers ist die in Form der Aktivierung einzelner oder mehrerer Schaltelemente 42 eingestellte Referenzspannung U_{Ref} abgreifbar. Die andere Seite des Spannungsteilers bildet ein Widerstand oder ein Widerstandsnetzwerk. Die Betriebsspannung U_{B} teilt sich in an sich bekannter Art proportional auf die beiden Seiten des Spannungsteilers auf. Je größer der Gesamtwiderstand der parallelen Pfade wird, desto mehr nähert sich die an der Referenzspannungsschaltung 40 abgreifbare Referenzspannung U_{Ref} der Betriebsspannung U_{B} an, so dass eine zunehmend höhere Referenzspannung U_{Ref} resultiert. Je geringer der Gesamtwiderstand der parallelen Pfade wird, desto geringer wird die an der Referenzspannungsschaltung 40 abgreifbare Referenzspannung U_{Ref}. Bei günstiger Wahl der Widerstandswerte der Referenzwiderstände 44 in den einzelnen parallelen Pfaden sind mit einer solchen Referenzspannungsschaltung 40 bis zu 2ⁿ Referenzspannungspegel einstellbar, wobei n für die Anzahl der parallelen Pfade steht. In der Darstellung in FIG 3 ist eine Referenzspannungsschaltung 40 mit drei parallelen Pfaden gezeigt.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen.

Einzelne im Vordergrund stehende Aspekte der hier eingereichten Beschreibung lassen sich damit kurz wie folgt zusammenfassen: Angegeben wird eine Leistungshalbleiterschaltung 30 mit einem zum Schalten einer Last 12 bestimmten Leistungshalbleiter 10 und mit einem mit einem ersten Eingang mittelbar oder unmittelbar an einen Anschlusspunkt der Last 12 am Leistungshalbleiter 10 angeschlossenen Komparator 32, dem an einem zweiten Eingang eine vorgegebene oder vorgebbare Referenzspannung U_{Ref} zuführbar ist, wobei mittels eines Ausgangs des Komparators 32 eine Aktivierung des Leistungshalbleiters 10 bewirkbar ist.

### Bezugszeichenliste

- 10: Leistungshalbleiter
- 12: Last
- 14: Signalquelle
- 16: Treiberschaltung
- 18: (erster) Treiberschalter
- 20: (zweiter) Treiberschalter
- 22: Z-Diode
- 24: Diode
- 26, 82: (frei)
- 30: Leistungshalbleiterschaltung
- 32: Komparator
- 34: Spannungsteiler
- 36: Z-Diode
- 38: (frei)
- 40: Referenzspannungsschaltung
- 42: Schaltelement
- 44: Referenzwiderstand

## Patentansprüche

1. Leistungshalbleiterschaltung (30) mit einem zum Schalten einer diskrete und/oder parasitäre Induktivitäten umfassenden Last (12) bestimmten Leistungshalbleiter (10),
wobei beim Abschalten der Last (12) mittels des Leistungshalbleiters (10) transiente Überspannungen resultieren,
und mit einem mit einem ersten Eingang mittelbar oder unmittelbar an einen Anschlusspunkt der Last (12) am Leistungshalbleiter (10) angeschlossenen Komparator (32), dem an einem zweiten Eingang eine vorgegebene oder vorgebbare Referenzspannung zuführbar ist,
wobei mittels eines Ausgangs des Komparators (32) eine Aktivierung des Leistungshalbleiters (10) bewirkbar ist,
wobei
die Referenzspannung mittels einer Referenzspannungsschaltung (40) einstellbar ist, an welcher im Betrieb eine Betriebsspannung anliegt, **dadurch gekennzeichnet, dass** die Referenzspannungsschaltung in parallelen Zweigen jeweils eine Reihenschaltung mit einem elektronischen Schaltelement (42) und einem Referenzwiderstand (44) aufweist, wobei alle von der Referenzspannungsschaltung (40) umfasste Schaltelemente (42) einzeln ansteuerbar sind, und dass die Betriebsspannung im Betrieb auch am Komparator anliegt.

2. Leistungshalbleiterschaltung (30) nach Anspruch 1, wobei dem Komparator (32) ein Spannungsteiler (34) vorgeschaltet ist.

3. Leistungshalbleiterschaltung (30) nach Anspruch 1 oder 2, wobei alle von der Referenzspannungsschaltung (40) umfasste Referenzwiderstände (44) unterschiedlich sind.

4. Verfahren zum Betrieb einer Leistungshalbleiterschaltung (30) nach einem der vorangehenden Ansprüche, wobei mittels einer vorgebbaren Referenzspannung eine Clamping-Spannung entsprechend einer jeweiligen Betriebssituation des Leistungshalbleiters (10) eingestellt wird.

5. Verfahren nach Anspruch 4, wobei der Clamping-Spannungspegel entsprechend einer jeweiligen Temperatur des Leistungshalbleiters (10) eingestellt wird.

## Claims

1. A power semiconductor circuit (30) comprising a power semiconductor device (10) for switching a load (12) comprising discrete and/or parasitic inductors,
wherein, when the load (12) is disconnected by means of the power semiconductor device (10), transient overvoltages result,
and with a comparator (32) which is directly or indirectly connected to a connection point of the load (12) to the power semiconductor device (10) by means of a first input and to which a predefined or predefinable reference voltage can be fed at a second input,
the power semiconductor device (10) being activatable by means of an output of the comparator (32),
wherein the reference voltage can be set by means of a reference voltage circuit (40), at which an operating voltage is applied during operation,
**characterized in that** the reference voltage circuit (40) has in parallel branches in each case a series circuit comprising an electronic switching element (42) and a reference resistor (44), wherein all switching elements (42) comprised by the reference voltage circuit (40) can be controlled individually, whereby the operating voltage is also applied to the comparator (32) during operation.

2. The power semiconductor circuit (30) according to claim 1, wherein a voltage divider (34) is arranged upstream of the comparator (32).

3. The power semiconductor circuit (30) according to claim 1 or 2, wherein all reference resistors (44) comprised by the reference voltage circuit (40) are different.

4. A method for operating a power semiconductor circuit (30) according to any one of the preceding claims, wherein a clamping voltage is set by means of a predefinable reference voltage in accordance with the particular operating situation of the power semiconductor device (10).

5. The method according to claim 4, wherein the clamping voltage level is set in accordance with the particular temperature of the power semiconductor device (10).

## Revendications

1. Circuit à semi-conducteur de puissance (30) avec un semi-conducteur de puissance (10) destiné à commuter une charge (12) comprenant des inductances discrètes et/ou parasites,
en ce que des surtensions transitoires se produisent lors de la coupure de la charge (12) au moyen du semi-conducteur de puissance (10),
et avec un comparateur (32) dont une première entrée est branchée directement ou indirectement à un point de branchement de la charge (12) au niveau du semi-conducteur de puissance (10), à une seconde entrée duquel peut être amenée une tension de référence prédéfinie ou qui peut être prédéfinie,
en ce qu'une activation du semi-conducteur de puissance (10) peut être effectuée par le biais d'une sortie du comparateur (32),
en ce que la tension de référence peut être réglée au moyen d'un circuit de tension de référence (40), sur lequel une tension de service est appliquée pendant le service, **caractérisé en ce que** le circuit de tension de référence comporte dans des branches parallèles respectivement un montage en série avec un élément de commutation électronique (42) et une résistance de référence (44), **en ce que** tous les éléments de commutation (42) compris dans le circuit de tension de référence (40) peuvent être commandés séparément et que la tension de service est également appliquée au comparateur pendant le service.

2. Circuit à semi-conducteur de puissance (30) selon la revendication 1, en ce qu'un diviseur de tension (34) est monté en amont du comparateur (32).

3. Circuit à semi-conducteur de puissance (30) selon la revendication 1 ou 2, en ce que toutes les résistances de référence (44) comprises dans le circuit de tension de référence (40) sont différentes.

4. Procédé permettant de faire fonctionner un circuit à semi-conducteur de puissance (30) selon l'une des revendications précédentes, en ce qu'une tension de blocage est réglée en fonction d'une condition de service respective du semi-conducteur de puissance (10) au moyen d'une tension de référence qui peut être prédéfinie.

5. Procédé selon la revendication 4, en ce que le niveau de tension de blocage est réglé en fonction d'une température respective du semi-conducteur de puissance (10).
